# EUROPEAN PATENT APPLICATION

(11) **EP 3 719 303 A1**
(43) Date of publication of application: **07.10.2020**
(21) Application number: 19166604.9
(22) Date of filing: 01.04.2019
(51) Int. Cl.: F03D 7/04, F03D 17/00, F03D 80/30

(54) **ELECTROMAGNETIC MEASUREMENTS FOR A WIND TURBINE**

(71) Applicant: Siemens Gamesa Renewable Energy A/S, 7330 Brande (DK)
(72) Inventor: Nagel, Eirik, 24939 Flensburg (DE); Nieuwenhuizen, John, 8700 Horsens (DK)
(74) Representative: Aspacher, Karl-Georg

(57) **Abstract**

Wind turbine (1) including a tower (2), a nacelle (3), at least one rotatable blade (4) and a measuring apparatus (100) for measuring electromagnetic waves including at least one electromagnetic waves sensor (101, 102, 103), wherein the electromagnetic waves sensor (101, 102, 103) includes at least one leaky feeder (20).

## Description

### Field of invention

The present invention relates to a wind turbine including a measuring apparatus for measuring electromagnetic waves. The measuring apparatus may be used for detecting and locating a lightning strike.

### Art Background

Sensors for measuring electromagnetic waves are typically provided in a wind turbine. Contactless devices like antennas, shunts or Rogowski coils may be used for such purposes. Such devices may be used to detect and measure electromagnetic waves emitted in neighboring cables, sparkling relay and lightning strikes.

The above described solution are therefore not yet optimal for a plurality of reasons, including the limited frequency range, lack of robustness and high costs.

### Summary of the Invention

Scope of the present invention is to provide a simple, efficient, robust and cost effective measuring apparatus for measuring electromagnetic waves, by solving the inconveniences mentioned with reference to the above cited prior art.

This scope is met by the subject matter according to the independent claims. Other advantageous embodiments of the present invention are described by the dependent claims.

According to the present invention a wind turbine includes a tower, a nacelle, at least one rotatable blade and a measuring apparatus for measuring electromagnetic waves including at least one electromagnetic waves sensor, wherein the electromagnetic waves sensor includes at least one leaky feeder.

With the term "leaky feeder" it is meant a communications elongated component, which leaks an electromagnetic wave which is transmitted along the component. The leaky feeder may be constituted by a leaky coaxial cable or a leaky waveguide or a leaky stripline. The leaky feeder is connected to the first communication device in order to transmit or receive the electromagnetic signal along the leaky feeder. The electromagnetic signal may travel through the leaky feeder towards or from a second communication device. The leaky feeder allows the first electromagnetic signal to leak out of the leaky feeder along its length and to be made available to the second communication device.

The solution provided by the use of a measuring apparatus including one or more leaky feeder is, with respect to other type of sensors including for example traditional antennas, robust, cheap and linear over a wider frequency range.

The characteristic of a detected electromagnetic field generated by a nearby current flowing can be analysed to derive the current parameters. Frequency and amplitude content of a current may be determined by using a conveninetly placed electromagnetic waves sensor including at least one leaky feeder. For example, a measuring apparatus according to the present invention may be used at a distance from the outer part of the tower, support structures, down conductors, cables from transformers, converters or any other electromagnetic field generating device.

According to embodiments of the present invention, the measuring apparatus may include on or electromagnetic waves sensor having at least one leaky feeder and a measurement circuit for each of the electromagnetic waves sensors. The leaky feeders may be attached to the conductive support (coupled mode) or extending in free space (radiating mode).

According to embodiments of the present invention, the measurement circuit may include a voltage measurement device for measuring a voltage difference between an outer conductor and an inner conductor of the leaky feeder. One terminal resistance may be provided between an outer conductor and an inner conductor of the leaky feeder. The termination resistance may be used to terminate the characteristic impedance correctly, in order to have an optimal frequency response.

According to embodiment of the present invention, the measurement circuit includes an analog-to-digital converter and a control process unit. Such embodiments allows signal processing of the signal measured by the leaky feeder and measured by the measurement circuit

According to embodiment of the present invention, the measuring apparatus includes at least three electromagnetic waves sensors and the measurement circuit is configured for measuring a distance between an hitting point of a lightning strike and each of the electromagnetic waves sensors. The measuring apparatus of the present invention is characterized by a high transducer factor. This causes a small voltage output, which for lightning detection and high current measurement provides the advantage of reducing the risk that a too high voltage output may damage the measurement circuit.

### Brief Description of the Drawings

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.
Fig. 1 shows a schematic section of a wind turbine including a measuring apparatus according to embodiments of the present invention.
Fig. 2 shows a first embodiment of the layout of an electromagnetic waves sensor included in the measuring apparatus of figure 1.
Fig. 3 shows a second embodiment of the layout an electromagnetic waves sensor included in the measuring apparatus of figure 1.
Fig. 4 shows a first embodiment of a functional scheme of an electromagnetic waves sensor included in the measuring apparatus of figure 1.
Fig. 5 shows a second embodiment of a functional scheme of an electromagnetic waves sensor included in the measuring apparatus of figure 1.
Fig. 6 shows a third embodiment of a functional scheme of an electromagnetic waves sensor included in the measuring apparatus of figure 1.
Fig. 7 shows a diagram illustrating a method for locating a lightning strike by means of the measuring apparatus of figure 1.

### Detailed Description

The illustrations in the drawings are schematically. It is noted that in different figures, similar or identical elements are provided with the same reference signs.

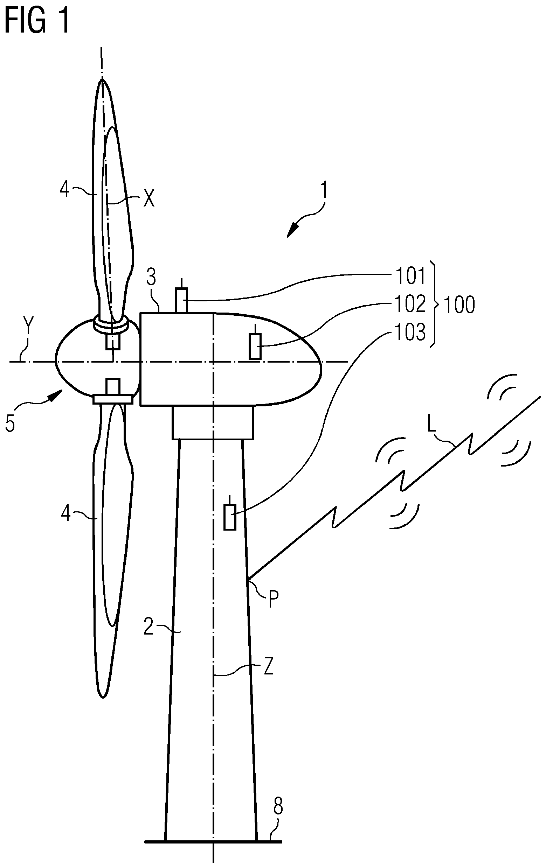

**Figure 1** shows a wind turbine 1 for generating electricity. The wind turbine 1 includes a measuring apparatus 100 for measuring electromagnetic waves according to the invention. The wind turbine 1 comprises a tower 2 which is mounted on the ground 8 at one bottom end. At the opposite top end of the tower 2 there is mounted a nacelle 3. The nacelle 3 accommodates the electrical generator (not shown in the attached figures) of the wind turbine 1. In between the tower 2 and the nacelle 3 a yaw angle adjustment device (not shown) is provided, which is capable of rotating the nacelle around a vertical yaw axis Z. The wind turbine 1 further comprises a wind rotor 5 having one or more rotational blades 4 (in the perspective of Figure 1 only two blades 4 are visible). The wind rotor 5 is rotatable around a rotational axis Y to transfer the rotational energy to the electrical generator of the nacelle 3. The generation of electrical power through the present invention is not a specific object of the present invention and therefore not described in further detail. In general, when not differently specified, the terms axial, radial and circumferential in the following are made with reference to the rotational axis Y. The blades 4 extend radially with respect to the rotational axis Y.

The measuring apparatus 100 comprises one or more electromagnetic waves sensors (three electromagnetic waves sensors 101, 102, 103 are shown in the embodiment of figure 1). Each of electromagnetic waves sensors 101, 102, 103 may be installed in any of the components of the wind turbine 1. In particular, each of the electromagnetic waves sensors 101, 102, 103 may be installed inside or on an outer surface of the tower 2 or the nacelle 3 or any of the blades 4. An electromagnetic waves sensor 101, 102, 103 may be provided distanced from the wind turbine 1, for example on the ground 8. Each of electromagnetic waves sensors 101, 102, 103 includes a leaky feeder 20 and a measurement circuit 30. The measuring apparatus 100 detects and measures electromagnetic waves emitted in neighboring cables, sparkling relay and lightning strikes. The performed measurements may include the measurement of the waveform of an electromagnetic wave.

According to another embodiment of the present invention (not shown), the measuring apparatus 100 may be included in a wind park and each the electromagnetic waves sensors 101, 102, 103 may be provided on respective wind turbines of the wind park.

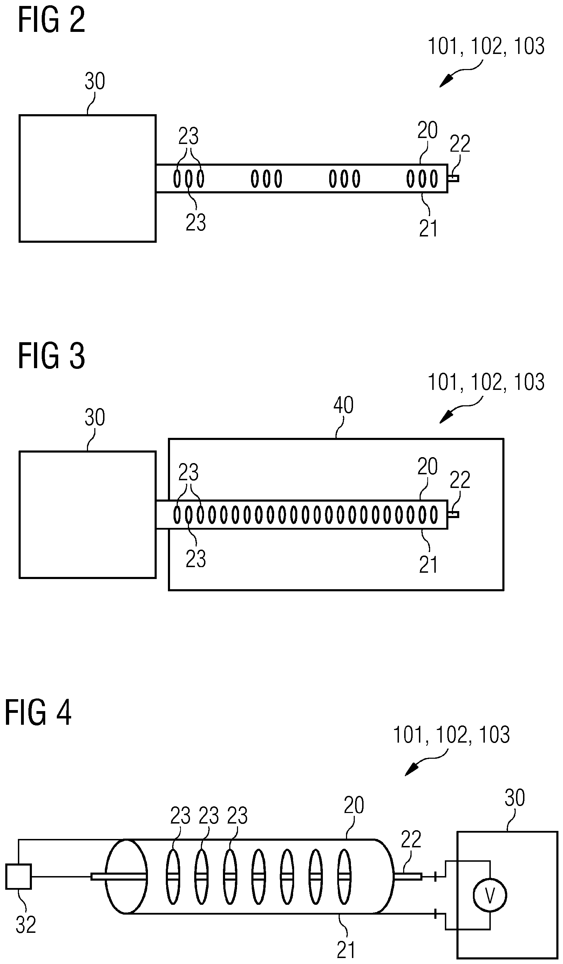

With reference to a first embodiment shown in **Figure 2**, an electromagnetic waves sensor 101, 102, 103 includes a leaky feeder 20 and a measurement circuit 30. The leaky feeder 20 is in a radiating mode, i.e. mounted in a free space. The leaky feeder 20 comprises an outer hollow conductor 21 and an inner conductor 22, coaxial with the outer conductor 21. A plurality of slots 23 are provided on the outer conductor 21. In the radiating mode of figure 2, the outer conductor 21 comprises radiating sections, i.e. sections provided with slots 23, alternating with non-radiating sections, i.e. sections not including any slot.

With reference to a second embodiment shown in **Figure 3**, an electromagnetic waves sensor 101, 102, 103 includes a leaky feeder 20 attached to a support 40 and a measurement circuit 30. The leaky feeder 20 is in a coupled mode, i.e. mounted to the support 40, which may be a metal plate or other conductive structure. The leaky feeder 20 comprises an outer hollow conductor 21 and an inner conductor 22, coaxial with the outer conductor 21. A plurality of slots 23 are provided on the outer conductor 21. In the coupled mode of figure 3, the slots 23 are continuously provided on the outer conductor 21, small distances being provided between the slots.

**Figure 4** shows a functional scheme of the electromagnetic waves sensor 101, 102, 103 included in the measuring apparatus 100. The measurement circuit 30 includes a voltage measurement device 31 (e.g. a voltmeter) at one end of the leaky feeder 20 connected to both the outer conductor 21 and the inner conductor 22, for measuring a voltage difference between the outer conductor 21 and the inner conductor 22. At the opposite end of the leaky feeder 20 a terminal resistance 32 is provided, connected to both the outer conductor 21 and the inner conductor 22.

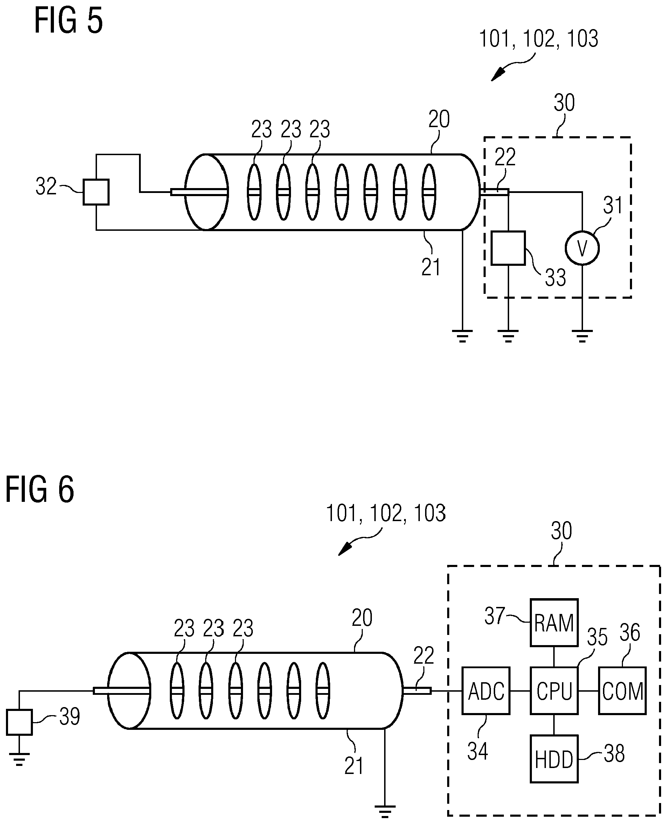

**Figure 5** shows a functional scheme of another possible embodiment for the electromagnetic waves sensor 101, 102, 103 included in the measuring apparatus 100. At one end of the leaky feeder 20 the measurement circuit 30 includes a voltage measurement device 31 connected between the inner conductor 22 and the ground and a terminal resistance 33 is also connected between the inner conductor 22 and the ground. The outer conductor is directly connected to the ground at the same end of the leaky feeder 20 where the measurement circuit 30 is provided. Similarly to the embodiment of figure 4, the voltage measurement device 31 measures a voltage difference between the outer conductor 21, kept at a ground voltage, and the inner conductor 22. At the opposite end of the leaky feeder 20 a terminal resistance 32 is provided, connected to both the outer conductor 21 and the inner conductor 22.

In both the embodiment of the figures 4 and 5, a voltage is measured by the voltage measurement device 31 each time the leaky feeder 20 is subject to an electromagnetic field. For example, the electromagnetic field may be emitted by neighboring cables, sparkling relay or lightning strikes. The voltage is proportional to the intensity of the electromagnetic field. The voltage at the end of the leaky feeder 20 depends on the length of the leaky feeder 20. The voltage also depends on the size and geometry of the slots 23. These parameters influence the frequency characteristics of the measuring apparatus 100 and may be conveniently chosen to be optimized for the typical lightning frequencies (<20 MHz).

**Figure 6** shows a functional scheme of yet another possible embodiment for the electromagnetic waves sensor 101, 102, 103 included in the measuring apparatus 100. At one end of the leaky feeder 20 the measurement circuit 30 includes an analog-to-digital converter 34 receiving as input a signal from the inner conductor 22 of the leaky feeder 20. The outer conductor is directly connected to the ground at the same end of the leaky feeder 20 where the measurement circuit 30 is provided. The measurement circuit 30 further includes:
a control process unit (CPU) 35 connected to the analog-to-digital converter 34,
a random access memory (RAM) 37 connected to the CPU 35,
a network interface 36 connected to the CPU 35,
a hard disk drive 38 connected to the CPU 35.

The CPU 35, together with the RAM 37 and the hard disk drive 38 provides a signal processing a storage unit. The network interface 36 provides to external communication network, for example a radio frequency (RF) transmitter or receiver (not shown in figure 6). At the opposite end of the leaky feeder 20 a terminal resistance 39 is provided connected to both the outer conductor 21 and the inner conductor 22. The measurement circuit 30 of the embodiment of figure 6 is usable to measure the intensity of an electromagnetic field, to which the leaky feeder 20. The intensity of an electromagnetic field may be calculated stored as a function of time.

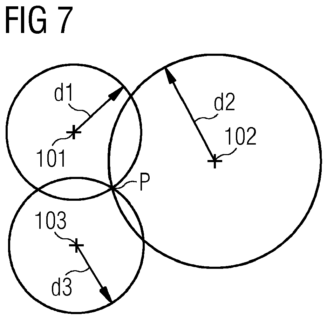

With reference to Figure 1 and **Figure 7**, a measuring apparatus 100 including at least electromagnetic waves sensor 101, 102, 103 can be used for locating a hitting point P of a lightning strike L. When a lightning strike occurs and a hitting point P is hit, the measuring apparatus 100 is triggered and each of the electromagnetic waves sensor 101, 102, 103 is activated for measuring a respective time of arrival t1, t2, t3, which corresponds to the time lights takes to travel between the hitting point P and the electromagnetic waves sensor 101, 102, 103, respectively. By multiplying each time of arrival t1, t2, t3 by the speed of light in air, the respective distances d1, d2 and d3 between the hitting point P and each of the electromagnetic waves sensor 101, 102, 103 is calculated. The hitting point P can be consequently be determined as the intersection between the three spheres having the electromagnetic waves sensor 101, 102, 103 as respective centres and the distances d1, d2, d3 as respective radiuses, as shown in figure 7.

Triggering of the system and synchronisation of time of impact can be for example derived from a GPS system for detailed timing analyses of lightning events. A further verification can be derived from the time of impact as reference (determined with the first detection of an electromagnetic signal) and the arriving sound boom from the lightning event detected by a sound sensor, for example a microphone or an accelerometer.

If at least one of the electromagnetic waves sensor 101, 102, 103 comprises a leaky feeder 20 mounted in a horizontal circular disposition, the direction along which the hitting point P lies could be detected on the horizontal plane by determining of a phase delay of the signal between the two ends of the leaky feeder 20. Directions on three mutually orthogonal planes can be obtained with the same approach (determination of a phase delay of the signal between the two ends of a leaky feeder 20) by using three leaky feeders 20 mounted in respective circular dispositions on three mutually orthogonal planes.

## Claims

1. Wind turbine (1) including a tower (2), a nacelle (3), at least one rotatable blade (4) and a measuring apparatus (100) for measuring electromagnetic waves including at least one electromagnetic waves sensor (101, 102, 103),
wherein the electromagnetic waves sensor (101, 102, 103) includes at least one leaky feeder (20).

2. Wind turbine (1) according to claim 1, wherein the electromagnetic waves sensor (101, 102, 103) includes at least one leaky feeder (20) and a measurement circuit (30).

3. Wind turbine (1) according to claim 2, wherein the electromagnetic waves sensor (101, 102, 103) further includes a conductive support (40), the at least one leaky feeder (20) being attached to the conductive support (40).

4. Wind turbine (1) according to claim 2 or 3, wherein the measurement circuit (30) includes a voltage measurement device (31) for measuring a voltage difference between an outer conductor (21) and an inner conductor of the leaky feeder (20) .

5. Wind turbine (1) according to claim 3 or 4, wherein the measurement circuit (30) includes at least one terminal resistance (32) between an outer conductor (21) and an inner conductor of the leaky feeder (20).

6. Wind turbine (1) according to any of the preceding claims 2 to 5, wherein the measurement circuit (30) includes an analog-to-digital converter (34) and a control process unit (35).

7. Wind turbine (1) according to any of the preceding claims 2 to 5, wherein the measuring apparatus (100) includes at least three electromagnetic waves sensors (101, 102, 103) and the measurement circuit (30) is configured for measuring a distance (d1, d2, d3) between an hitting point (P) of a lightning strike and each of the electromagnetic waves sensors (101, 102, 103).
